# EUROPÄISCHE PATENTSCHRIFT

(11) **EP 3 258 757 B1**
(45) Veröffentlichungstag und Bekanntmachung des Hinweises auf die Patenterteilung: **23.01.2019**
(21) Anmeldenummer: 17000992.2
(22) Anmeldetag: 12.06.2017
(51) Int. Cl.: H05K 7/20, H05K 5/00, H02B 1/56, H02B 1/28, H02G 3/18, H02G 3/38, H02G 3/03, H02G 9/10

(54) **UNTERFLURVERTEILER FÜR ELEKTRISCHE UND/ODER ELEKTRONISCHE EINRICHTUNGEN**
UNDERFLOOR DISTRIBUTOR FOR ELECTRICAL AND/OR ELECTRONIC UNITS
RÉPARTITEUR ENCASTRÉ POUR DISPOSITIFS ÉLECTRIQUES ET/OU ÉLECTRONIQUES

(30) Priorität: 15.06.2016 DE 102016007235
(43) Veröffentlichungstag der Anmeldung: 20.12.2017
(73) Patentinhaber: Langmatz GmbH, 82467 Garmisch-Partenkirchen (DE)
(72) Erfinder: Rüttiger, Steffen, 82490 Farchant (DE); Hutter, Michael, 82497 Unterammergau (DE)
(74) Vertreter: Flosdorff, Jürgen

(56) Entgegenhaltungen:
- WO-A1-2008/106818
- WO-A1-2009/133416
- DE-A1-102014 017 720
- DE-U1-202007 004 293

## Beschreibung

Die Erfindung betrifft einen Unterflurverteiler für elektrische und/oder elektronische Einrichtungen, insbesondere der Telekommunikation, mit einem Unterflur in den Boden einbaubaren Schacht, der wenigstens einen Deckel und eine luftdichte Haube aufweist, die aus einer horizontalen Lage in dem Schacht, bei der die Unterseite der Haube offen ist, in eine vertikale Lage nach oben schwenkbar angeordnet ist, und in der die elektrischen und/oder elektronischen Einrichtungen angeordnet sind. Die Haube ist in die bevorzugt vertikale Lage hochklappbar, damit die darin angeordneten elektrischen und/oder elektronischen Einrichtungen für einen Monteur zu Installations-, Bedienungs- und Wartungsarbeiten zugänglich sind. In der horizontalen Ausgangslage schützt die luftdichte Haube nach Art einer Tauchglocke die darin angeordneten Komponenten bei einem Wassereinbruch in den Schacht vor der Berührung mit dem Wasser, das nur in einer sehr geringen Höhe in die Haube unten eindringen kann.

Bei einem Betrieb der elektrischen/elektronischen Komponenten entsteht beispielsweise durch eine hohe Belegung von Teilnehmern bei Telekommunikationseinrichtungen eine große Verlustleistung, die zu so hohen Temperaturen unter der luftdichten Haube führen kann, das einzelne oder alle elektrischen und/oder elektronischen Komponenten ausfallen und sogar dauerhaft beschädigt werden können.

Die WO2009/133416 A1 offenbart einen Unterflurverteiler für elektrische Einrichtungen, die in einer luftdichten Haube angeordnet sind, die aus einer horizontalen Lage in einem unterflur in den Boden eingebauten Schacht in eine vertikale Lage schwenkbar ist, in der die Haube oben aus dem Schacht heraus ragt. Die luftdichte Haube ist an ihrem in der Einbaulage unteren Endbereich mit einer Basisplatte versehen, die eine Durchlassöffnung für kalte Luft enthält, die durch eine Öffnung in einem Schachtdeckel in den Innenraum der Haube eingesaugt wird. Die erwärmte Luft in den Innenraum der Haube wird durch ein Gebläse durch ein Rohr aus der Haube abgeführt und tritt durch eine andere Öffnung eines Gehäusedeckels aus dem Schacht aus. Eine ähnliche Anordnung ist in der WO2008/106818 A1 offenbart.

Die DE 10 2014 017 720 A1 offenbart eine Unterflur-Anordnung von elektrischen und/oder elektronischen Einrichtungen, bei der eine luftdichte Haube nicht aus einer horizontalen Lage in eine vertikale Lage nach oben schwenkbar ist, sondern die nach oben abnehmbar angeordnet ist. Elektrische und/oder elektronische Komponenten sind auf einer Montageplatte angeordnet, die durch eine sich am Schachtboden abstützende Hebeanlage mittels eines Motors angehoben oder abgesenkt werden kann. Die Einbauten sind von einer Thermohaube überdeckt, die in der luftdichten Haube angeordnet ist. Die Thermohaube ist entweder durch Perforierung ihrer oberen Wand luftdurchlässig oder auf andere Weise wärmedurchlässig ausgebildet. Zwischen der Thermohaube und der luftdichten Haube besteht ein Zwischenraum, der von Kaltluft durchströmt wird. Die Wärme der Thermohaube entweicht durch ihre wärmedurchlässige Wand in den darüber befindlichen kühlenden Luftstrom.

Der vorliegenden Erfindung liegt die Aufgabe zugrunde, diese schädliche Wärme wirkungsvoll abzuführen und dabei den Schutz vor eindringendem Wasser beizubehalten. Diese Aufgabe wird erfindungsgemäß durch die Merkmale des Patentanspruchs 1 gelöst.

Vorteilhafte Ausgestaltungen der Erfindung sind in den Unteransprüchen gekennzeichnet.

Die Erfindung sieht vor, dass in der Haube ein Gehäuse befestigt ist, in dem die elektrischen und/oder elektronischen Einrichtungen gekühlt werden. Das Gehäuse ist so an der Haube befestigt, dass das Gehäuse mit der Haube verschwenkt wird, wenn die Haube nach oben geklappt wird.

Das Gehäuse enthält eine Kaltluft-Kammer und wenigstens eine weitere getrennte Kammer, die mit der Kaltluft-Kammer in Strömungsverbindung steht. In der Kaltluft-Kammer ist bevorzugt wenigstens ein Lüfter, bevorzugt mehrere Lüfter angeordnet, die kalte Zuluft, die aus der Umgebung des Schachtes stammt, in die Kaltluftkammer ansaugen. Der bzw. die Lüfter drücken die Kaltluft in die wenigstens eine getrennte Kammer, in der elektrische und/oder elektronische Einrichtungen angeordnet sind, wobei die unter Druck die wenigstens eine getrennte Kammer durchströmende Kaltluft die elektrischen und/oder elektronischen Einrichtungen kühlt. Die so erwärmte Luft tritt aus der getrennten Kammer und im weiteren Verlauf unten aus der Haube aus und verlässt den Schacht durch Öffnungen in dem wenigstens einen Deckel des Schachtes.

Die wenigstens eine getrennte weitere Kammer ist bevorzugt seitlich an der Kaltluft-Kammer befestigt, wobei mit großem Vorteil vorgesehen ist, dass an beiden Seiten der Kaltluft-Kammer jeweils eine getrennte weitere Kammer befestigt ist, die beide mit der Kaltluft-Kammer durch Öffnungen, insbesondere Schlitze in den Seitenwänden der Kaltluft-Kammer, mit dieser in Strömungsverbindung stehen.

In der horizontalen Einbaulage der Haube hat die Kaltluft-Kammer im Bodenbereich eine vorzugsweise kreisrunde Öffnung, in die ein Rohr einmündet, durch das die Kaltluft zugeführt wird, die von dem wenigstens einen Lüfter, bevorzugt von zwei oder drei nebeneinander angeordneten Lüftern angesaugt wird, die in der Kaltluft-Kammer angeordnet sind. Die Lüfter drücken die Kaltluft nach oben, wobei sie durch im oberen Bereich angeordnete, beidseitige Schlitze oben in die seitlichen Kammern eintreten und diese nach unten durchströmen. Dabei kühlt die Luft die übereinander angeordneten elektrischen und/oder elektronischen Komponenten, die vorzugsweise mit Kühlrippen versehen sind, wobei die dabei erwärmte Luft aus den unten offenen seitlichen Kammern ausströmt. Die erwärmte Luft strömt infolge des von den Lüftern erzeugten Drucks unten aus der offenen Haube aus und verlässt den Schacht über die über den Deckel verteilten Austrittsöffnungen.

Wie oben erwähnt, ist das zur Kühlung der elektrischen und/oder elektronischen Komponenten vorgesehene Gehäuse gemeinsam mit der Haube verschwenkbar, wobei im hoch geklappten Zustand die Komponenten durch den offenen Boden der seitlichen Kammern für einen Monteur zugänglich sind. Beim Hochklappen der Haube und damit des Gehäuses wird dessen Verbindung mit dem am Boden des Schachtes fixierten Schlauch getrennt. Hierzu ist mit großem Vorteil vorgesehen, dass das Ende des Kaltluft-Rohres von einer Halterung in dem Schacht in der Position fixiert ist, in der es in die Öffnung des Bodenbereichs der Kaltluft-Kammer eingreift. Ein glattes Eintreten bzw. Austreten des Rohres in bzw. aus der Öffnung der Kaltluft-Kammer wird bevorzugt dadurch erreicht, dass die Öffnung des Bodenbereichs der Kaltluft-Kammer im horizontalen Zustand der Haube in einer geneigt zur horizontalen verlaufenden Bodenwand der Kaltluft-Kammer ausgebildet ist, und dass die Halterung das Ende des Kaltluft-Rohres entsprechend geneigt fixiert. Hierdurch kann das Ende des Kaltluft-Rohres glatt aus der Öffnung austreten und wieder in die Öffnung eintreten, ohne dass hierzu ein Handgriff eines Monteurs erforderlich ist.

Der Schacht kann einen oder mehr Deckel haben. An einem Randbereich des oder eines der Deckel ist wenigstens eine Öffnung zum Eintritt von Kaltluft in den Schacht ausgebildet, wobei der Bereich unter dieser wenigstens einen Öffnung beispielsweise durch Bleche von dem übrigen Schachtinneren abgeschirmt ist, so dass die erwärmte Luft nicht in den Bereich eintreten kann. In diesen abgeschirmten Kaltluft-Bereich ragt nach einem weiteren Vorschlag das Ende des Kaltluft-Rohres hinein. Die Austrittsöffnungen für die erwärmte Luft sind bevorzugt über die Deckelfläche verteilt.

Der erfindungsgemäße Unterflurverteiler kühlt die elektrischen/elektronischen Bauteile sehr wirkungsvoll in dem hierzu vorgesehenen Kühl-Gehäuse mit geringem Energieaufwand, mit dem Kaltluft in das Gehäuse eingesaugt und höchst wirkungsvoll durch schmale Luftkanäle in den seitlichen Kammern an den elektrischen/elektronischen Bauteilen vorbei gedrückt wird, wobei die erwärmte Luft ohne weitere Hilfsmittel aus dem Schacht austritt.

Weitere Einzelheiten des erfindungsgemäßen Unterflurverteilers ergeben sich aus der nachfolgenden Beschreibung einer bevorzugten Ausführungsform sowie anhand der Zeichnungen. Dabei zeigen:
- Figur 1: eine perspektivische Darstellung des Schachts des Unterflurverteilers;
- Figur 2: einen mittigen Längsschnitt durch den Unterflurverteiler;
- Figur 3: einen hierzu senkrechten Querschnitt durch den Unterflurverteiler;
- Figur 4: den linken Randbereich des Unterflurverteilers gemäß Figur 1 in einer Schnittdarstellung;
- Figur 5: eine perspektivische Darstellung des Kühlgehäuses des Unterflurverteilers;
- Figur 6: das Kühlgehäuse der Figur 5 in dem in die luftdichte Haube eingebauten Zustand, wobei die Haube hoch geklappt ist;
- Figur 7: eine Darstellung ähnlich Figur 6, jedoch ohne elektrische/elektronische Bauteile in dem Kühlgehäuse;
- Figur 8: einen mittigen Längsschnitt durch das Kühlgehäuse ohne elektrische/elektronische Bauteile;
- Figur 9: eine ähnliche Darstellung wie Figur 8 jedoch mit elektrischen/elektronischen Bauteilen;

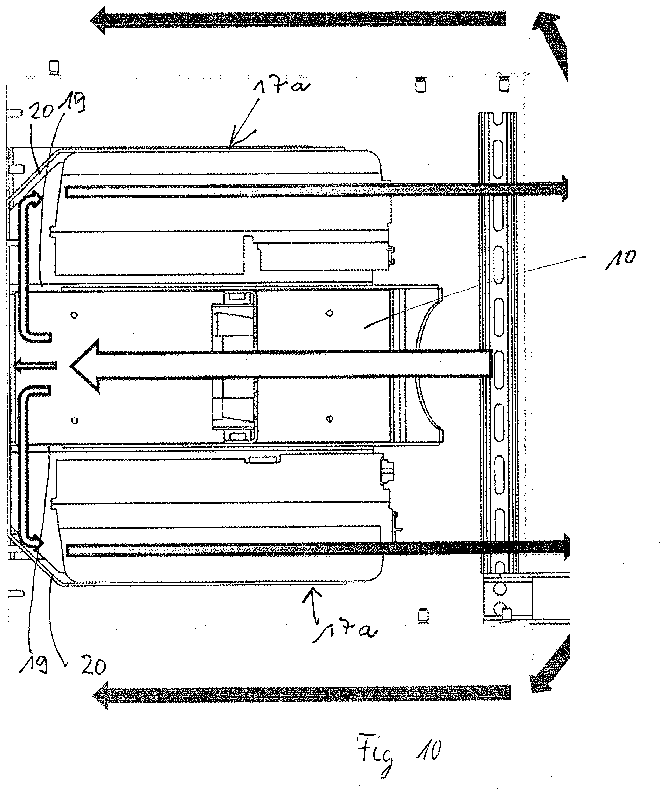

- Figur 10: einen Schnitt durch das Kühlgehäuse mit schematischer Darstellung der Luftströme.

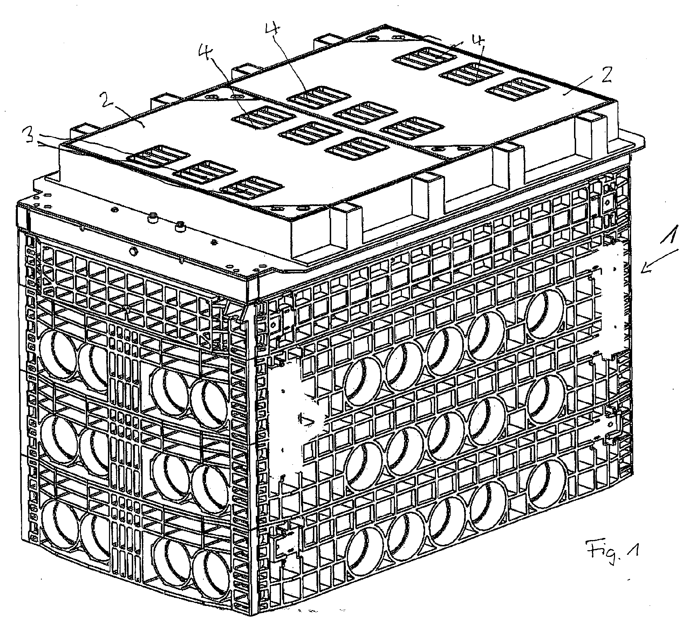

Figur 1 zeigt einen Kunststoffschacht 1, der durch zwei Deckel 2 verschlossen ist. Der in der Figur 1 linke Deckel enthält einen Bereich beispielsweise mit drei Öffnungen 3 zum Eintritt von Kaltluft. Außerdem enthalten die beiden Deckel noch drei Bereiche, beispielweise mit insgesamt neun Öffnungen 4 für warme Abluft.

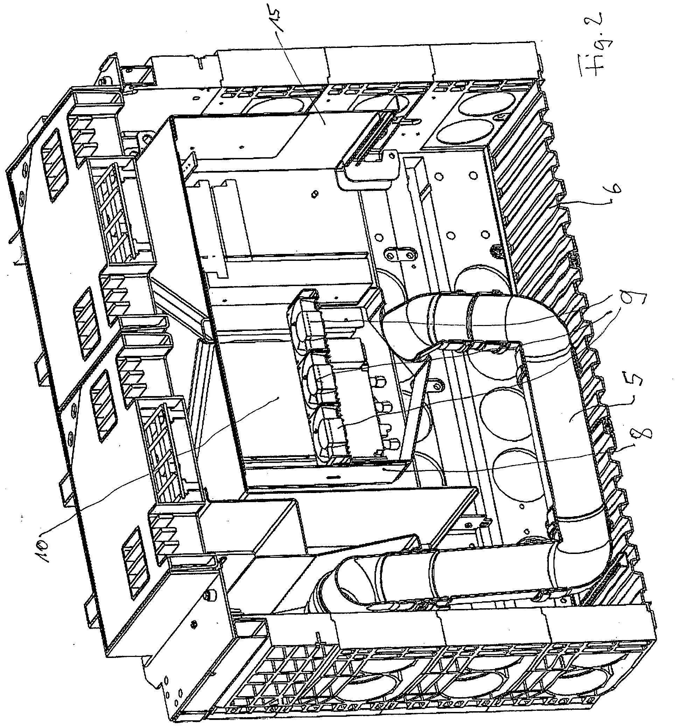

Der mittige Vertikalschnitt der Figur 2 offenbart ein Rohr 5, das von dem linken oberen Endbereich zum Boden 6 des Schachtes führt, an dem ein anschließender horizontaler Abschnitt des Rohres 5 befestigt ist, woraufhin das Rohr 5 nach oben verläuft und in eine Öffnung 7 im Bodenbereich eines insgesamt mit dem Bezugszeichen 8 bezeichneten Kühlgehäuses einmündet. Durch das Rohr 5 wird kalte Luft aus der Umgebung des Schachtes 1 in das Kühlgehäuse 8 auf die weiter unten näher beschriebene Weise eingeführt. In dem Kühlgehäuse 8 sind drei Lüfter 9 nebeneinander angeordnet, die im wesentlichen den gesamten Querschnitt einer Kaltluft-Kammer 10 des Kühlgehäuses 8 ausfüllen.

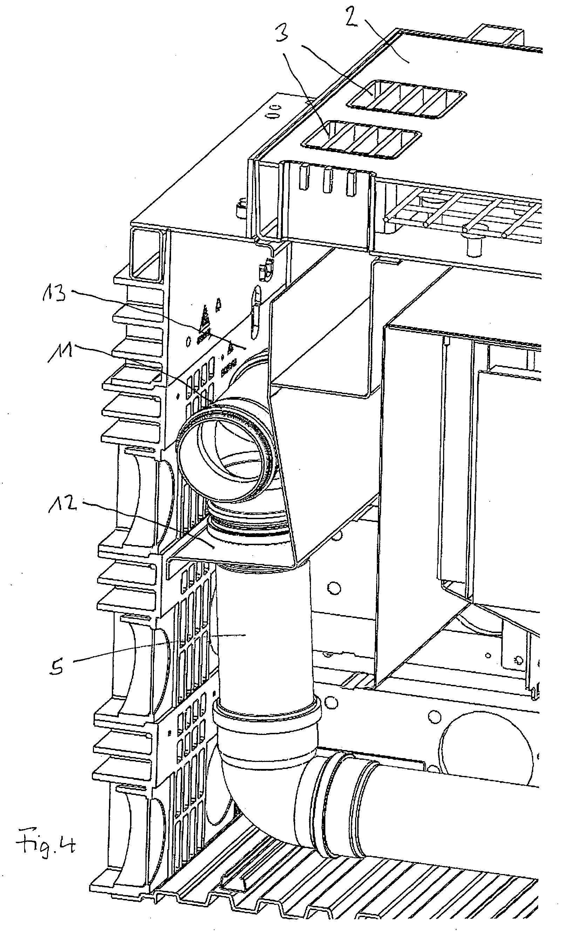

Wie Figur 4 zeigt, ist der abgewinkelte obere Endabschnitt 11 des Rohres 5 in einem durch Bleche 12 von dem übrigen Innenraum des Schachtes 1 abgeschirmten Bereich 13 angeordnet, in den kalte Umgebungsluft durch die Öffnungen 3 in dem Deckel eingesaugt wird.

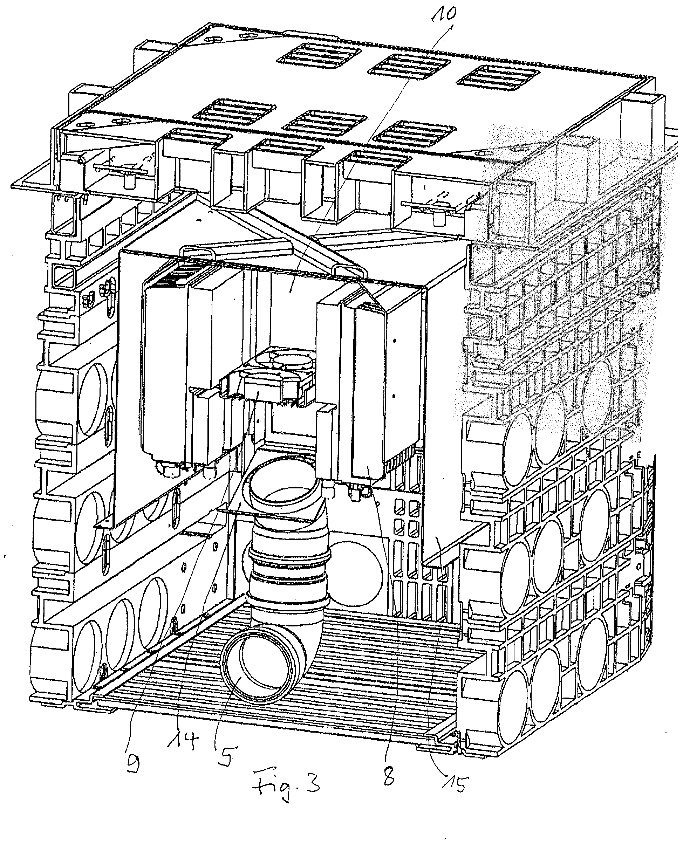

Figur 3 zeigt, dass der untere Endabschnitt des Rohres 5 von einer Halterung 14 in schräger Lage fixiert ist.

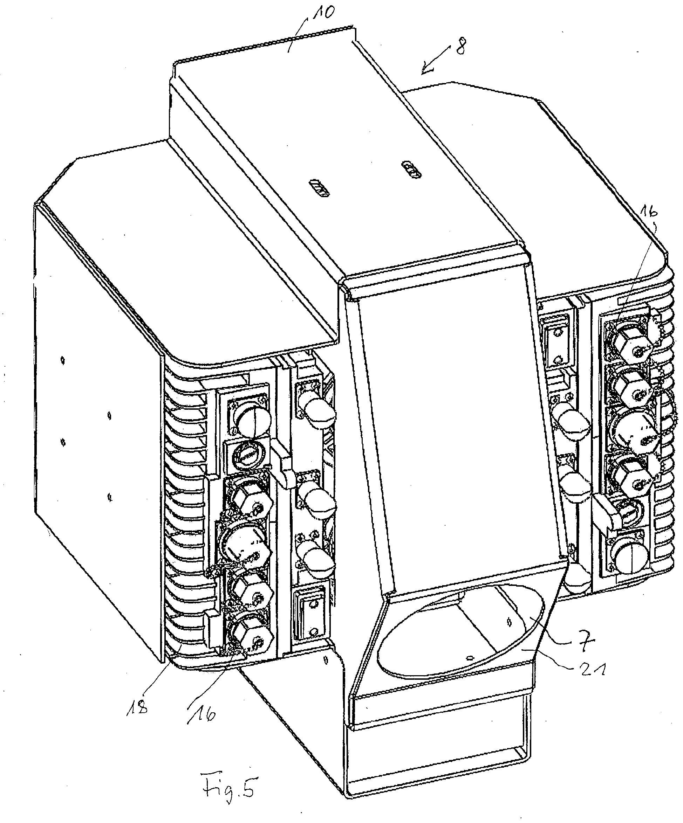

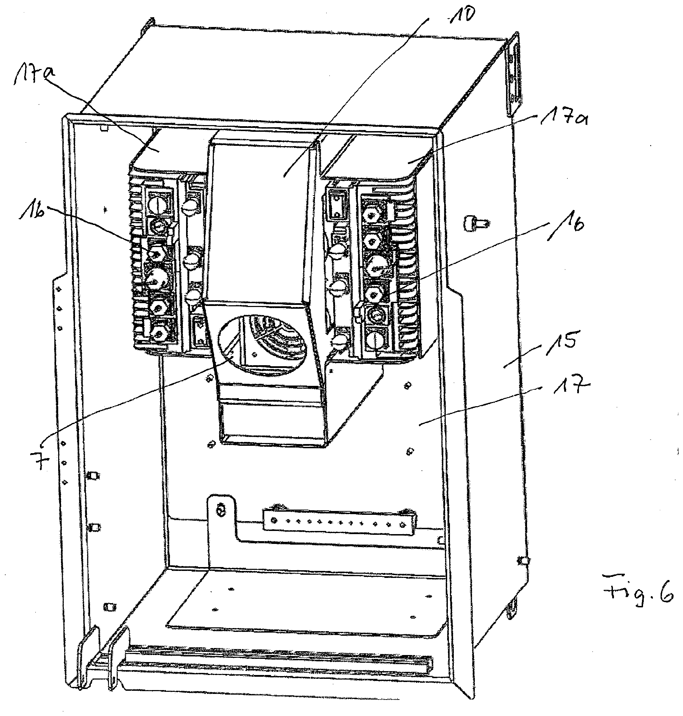

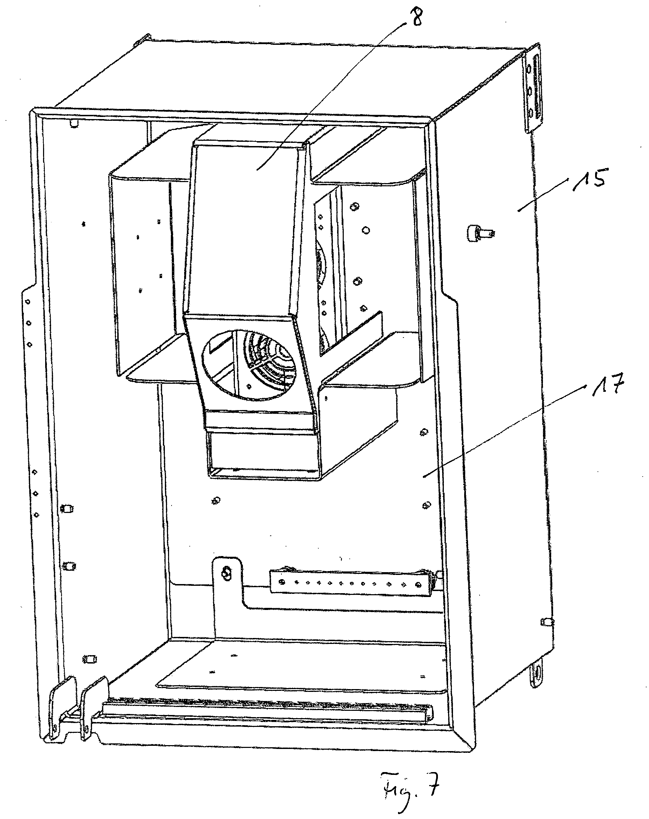

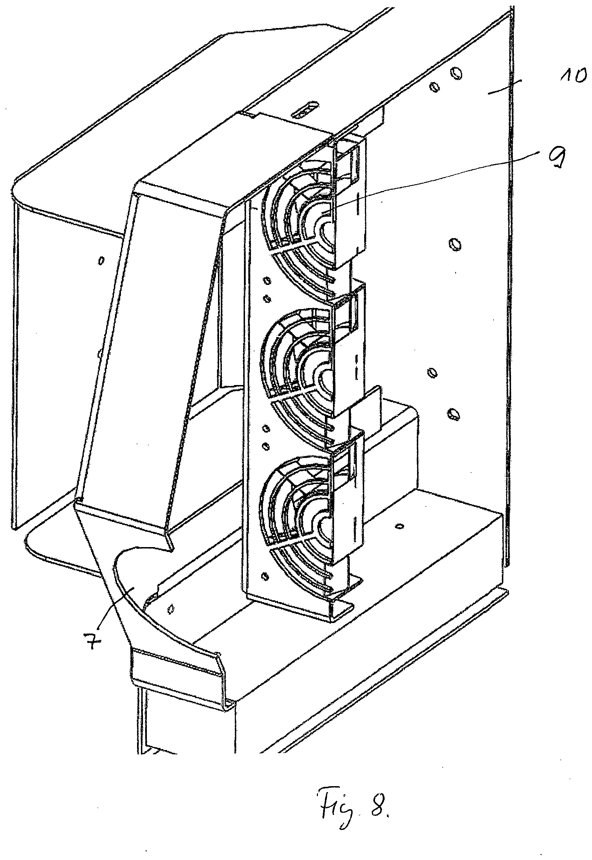

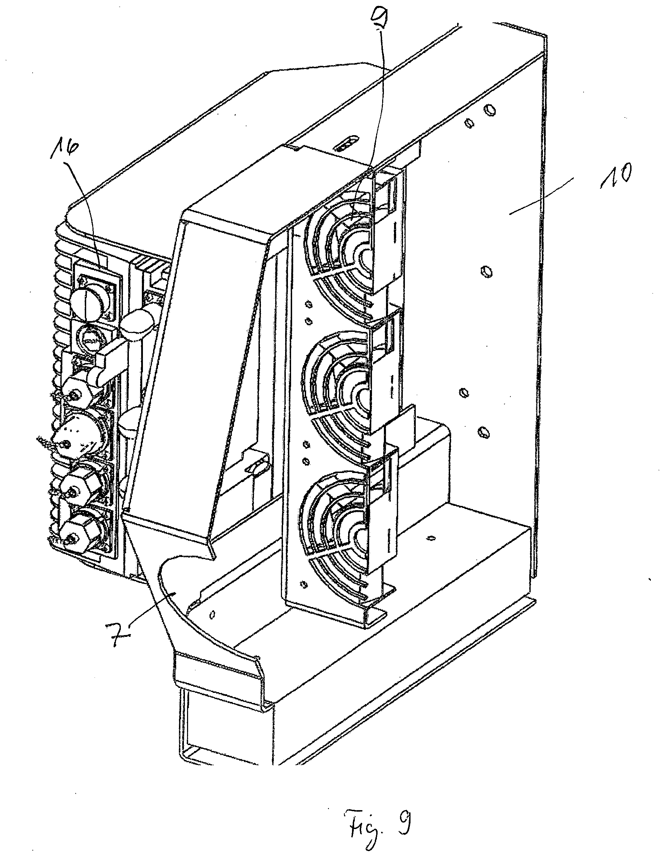

Wie insbesondere die Figuren 6 und 7 zeigen, ist das Kühlgehäuse 8 an der Rückwand der luftdichten Haube 15 befestigt, die in der Einbaulage in dem Schacht 1 gemäß den Figuren 2 bis 4 als obere Wand horizontal angeordnet und unten offen ist. Die Haube 15 verhindert bei einem Wassereinbruch in den Schacht 1, dass Wasser in die Haube 15 bis zu elektrischen/elektronischen Bauteilen 16 eindringt, die in dem Kühlgehäuse 8 befestigt sind. Das Kühlgehäuse 8 ist somit gemeinsam mit der Haube 15 schwenkbar. Die Figuren 5 bis 9 zeigen Darstellungen des Kühlgehäuses 8 in einem nach oben verschwenkten Zustand.

Das Kühlgehäuse 8 hat eine mittige Kaltluft-Kammer 10, die in der Einbaulage die bereits oben erwähnte Öffnung 7 aufweist, in die das untere Ende des Rohres glatt eingreift. An beiden Seiten der Kaltluft-Kammer 10 ist jeweils eine weitere Kammer 17a befestigt, in der ein Bausatz von elektrischen/elektronischen Bauteilen 16 mit Kühlrippen übereinander (in den Darstellungen der Figuren 5 bis 9) angeordnet sind. Die weiteren Kammern 17a sind im hochgeklappten Zustand der Haube 15 zur Vorderseite hin offen, so dass die elektrischen/elektronischen Bauteil für einen Monteur bequem erreichbar sind. In der Ausgangslage in dem Schacht liegt die offene Seite der seitlichen Kammern 17a unten.

Die Kaltluft-Kammer 10 steht mit den seitlichen Kammern 17a durch Schlitze 19 in den Seitenwänden in Strömungsverbindung. Leitbleche 20 in den seitlichen Kammern 17a tragen dazu bei, dass die Kaltluft aus der Kaltluft-Kammer 10 glatt durch die Anordnung der elektrischen/elektronischen Bauteile 16 strömt und diese wirkungsvoll kühlt. In der Einbaulage in dem geschlossenen Schacht strömt somit die kalte Luft in der Kaltluft-Kammer 10 zunächst nach oben, strömt durch seitliche Schlitze in die Seitenkammern 17a und dort nach unten, wo dann die erwärmte Luft unten aus den Seitenkammern 17a und dann aus der Haube 15 sowie den Öffnungen 4 in den Deckeln 2 in die Umgebung austritt.

Es wird betont, dass die Erfindung nicht auf die beschriebenen und dargestellten Ausführungsformen beschränkt ist, Vielmehr sind alle offenbarten Merkmale auf jede sinnvolle Weise einzeln miteinander kombinierbar.

## Patentansprüche

1. Unterflurverteiler für elektrische und/oder elektronische Einrichtungen insbesondere der Telekommunikation, mit einem unterflur in den Boden einbaubaren Schacht, der wenigstens einen Deckel und eine luftdichte Haube aufweist, in der die elektrischen und/oder elektronischen Einrichtungen angeordnet sind, und die aus einer horizontalen Lage in dem Schacht, bei der die Unterseite der Haube offen ist, in eine vertikale Lage nach oben schwenkbar angeordnet ist,
wobei in der Haube (15) ein Gehäuse (8) befestigt ist, das eine Kaltluft-Kammer (10) und wenigstens eine weitere getrennte Kammer (17a) aufweist, wobei in dem wenigstens einen Deckel (2) an einem Randbereich wenigstens eine Öffnung (3) zum Eintritt von Kaltluft in den Schacht (1) ausgebildet ist, wobei der Bereich (13) unter dieser wenigstens einen Öffnung (3) durch Bleche (12) von dem übrigen Schacht (1) abgeschirmt ist und
wobei das obere Ende (11) eines Kaltluft-Rohres (5) in diesen Bereich hinein ragt,
wobei die Kaltluft-Kammer (10) im Bodenbereich eine Öffnung (7) hat, in die das Kaltluft-Rohr (5) einmündet,
wobei die Kaltluft-Kammer (10) mit der wenigstens einen getrennten weiteren Kammer (17a) in Strömungsverbindung steht,
wobei in der wenigstens einen getrennten Kammer die elektrischen und/oder elektronischen Einrichtungen angeordnet sind,
wobei die wenigstens eine weitere Kammer (17a) darauf ausgelegt ist, dass von der unter Druck stehenden Kaltluft durchströmt wird, die dabei die elektrischen und/oder elektronischen Einrichtungen (16) kühlt, und
wobei die Anordnung aus Haube (15) und Kammer (17a) so ausgelegt ist, dass die so erwärmte Luft aus der wenigstens einen weiteren getrennten Kammer (17a) und dann unten aus der Haube (15) austritt und den Schacht (1) durch Öffnungen (4) in dem wenigstens einen Deckel (2) verlässt.

2. Unterflurverteiler nach Anspruch 1,
**dadurch gekennzeichnet,**
**dass** die wenigstens eine getrennte weitere Kammer (17a) seitlich an der Kaltluft-Kammer (10) befestigt ist.

3. Unterflurverteiler nach Anspruch 1,
**dadurch gekennzeichnet,**
**dass** an beiden gegenüber liegenden Seiten der Kaltluft-Kammer (10) jeweils eine getrennte weitere Kammer (17a) befestigt ist.

4. Unterflurverteiler nach einem der Ansprüche 1 bis 3,
**dadurch gekennzeichnet,**
**dass** in der Kaltluft-Kammer (10) wenigstens ein Lüfter (9) angeordnet ist, der ausgelegt ist, Kaltluft anzusaugen.

5. Unterflurverteiler nach einem der Ansprüche 1 bis 4,
**dadurch gekennzeichnet,**
**dass** die Kaltluft-Kammer (10) durch Öffnungen (19) in einer Seitenwand/Seitenwänden mit der/den weiteren Kammer(n) (17a) in Strömungsverbindung steht, so dass die Kaltluft in die weitere/weiteren Kammer(n) (17a) gedrückt wird.

6. Unterflurverteiler einem der Ansprüche 1 bis 5,
**dadurch gekennzeichnet,**
**dass** dieser darauf ausgelegt ist, dass die Kaltluft im oberen Bereich der weiteren Kammer(n) (17a) eintritt und durch deren offenen Boden austritt.

7. Unterflurverteiler nach einem der Ansprüche 1 bis 6,
**dadurch gekennzeichnet,**
**dass** das Ende des Kaltluft-Rohres (5) von einer Halterung (14) in dem Schacht (1) in der Position fixiert ist, in der es in die Öffnung (7) des Bodenbereiches der Kaltluft-Kammer (10) eingreift.

8. Unterflurverteiler nach einem der Ansprüche 1 bis 7,
**dadurch gekennzeichnet,**
**dass** die Öffnung (7) des Bodenbereichs der Kaltluft-Kammer (10) in einer geneigt verlaufenden Bodenwand (21) ausgebildet ist und dass die Halterung (14) das Ende des Kaltluft-Rohres (5) entsprechend geneigt fixiert, derart, dass beim Verschwenken der Haube (15) das Ende des Kaltluft-Rohres (5) glatt aus der Öffnung (7) austreten und wieder in die Öffnung (7) eintreten kann.

9. Unterflurverteiler nach einem der Ansprüche 1 bis 8,
**dadurch gekennzeichnet,**
**dass** in dem wenigstens einen Deckel (2) drei Bereiche, beispielsweise mit insgesamt neun Öffnungen (4) zum Austritt der erwärmten Luft ausgebildet sind.

## Claims

1. An underfloor distributor for electrical and/or electronic devices, particularly for telecommunications, with a duct which is installable in the ground under the floor, which has at least one cover and an airtight cap, in which the electrical and/or electronic devices are arranged and which is arranged to be pivotable upwardly out of a horizontal position in the duct, in which the bottom of the cap is open, into a vertical position, wherein secured in the cap (15) there is a housing (8), which includes a cold air chamber (10) and at least one further separate chamber (17a), wherein formed in the at least one cover (2) on an edge region there is at least one opening (3) for the entry of cold air into the duct (1), wherein the region (13) below this at least one opening (3) is shielded by plates (12) of the remaining duct (1) and wherein the upper end (11) of a cold air pipe (5) projects into this region, wherein in the base region the cold air chamber (10) has an opening (7), with which the cold air pipe (5) communicates, wherein the cold air chamber (10) is in flow communication with the at least one separate further chamber (17a), wherein the electrical and/or electronic devices are arranged in the at least one separate chamber, wherein the at least one further chamber (17a) is designed so that the cold air under pressure flows through it and thus cools the electrical and/or electronic devices and wherein the arrangement consisting of cap (15) and chamber (17a) is so designed that the thus heated air discharges out of the at least one further separate chamber (17a) and then downwardly out of the cap (15) and leaves the duct (1) through openings (4) in the at least one cover (2).

2. An underfloor distributor as claimed in Claim 1, **characterised in that** the at least one separate further chamber (17a) is fastened laterally to the cold air chamber (10).

3. An underfloor distributor as claimed in Claim 1, **characterised in that** a respective separate further chamber (17a) is fastened to both opposing sides of the cold air chamber (10).

4. An underfloor distributor as claimed in one of Claims 1 to 3, **characterised in that** arranged in the cold air chamber (10) there is at least one fan (9), which is designed to draw in cold air.

5. An underfloor distributor as claimed in one of Claims 1 to 4, **characterised in that** the cold air chamber (10) is in flow communication through openings (19) in a side wall/side walls with the further chamber(s) (17a) so that the cold air is forced into the further chamber(s) (17a).

6. An underfloor distributor as claimed in one of Claims 1 to 5 **characterised in that** it is so designed that the cold air enters in the upper region of the further chamber(s) (17a) and discharges through its open base.

7. An underfloor distributor as claimed in one of Claims 1 to 6, **characterised in that** the end of the cold air pipe (5) is fixed by a holder (14) in the shaft (1) in the position in which it engages into the opening (7) in the base region of the cold air chamber (10).

8. An underfloor distributor as claimed in one of Claims 1 to 7, **characterised in that** the opening (7) in the base region of the cold air chamber (10) is formed in an inclined base wall (21) and that the holder (14) fixes the end of the cold air pipe (5) in a correspondingly inclined position such that when the cap (15) is pivoted the end of the cold air pipe (5) can move smoothly out of the opening (7) and move back into the opening (7) again.

9. An underfloor distributor as claimed in one of Claims 1 to 8, **characterised in that** three regions, for instance with a total of nine openings (4) for the outlet of the heated air are formed in the at least one cover (2).

## Revendications

1. Répartiteur encastré pour dispositifs électriques et/ou électroniques en particulier de télécommunication, avec une cage pouvant être montée de manière encastrée dans le sol, qui présente au moins un couvercle et un capot étanche à l'air, dans lequel les dispositifs électriques et/ou électroniques sont disposés, et qui est disposé de manière à pouvoir pivoter vers le haut depuis une position horizontale dans la cage, dans laquelle le côté inférieur du capot est ouvert, dans une position verticale,
dans lequel est fixé dans le capot (15) un boîtier (8), qui présente une chambre d'air froid (10) et au moins une autre chambre (17a) séparée, dans lequel au moins une ouverture (3) servant à l'entrée d'air froid dans la cage (1) est réalisée dans l'au moins un couvercle (2) au niveau d'une zone de bord, dans lequel la zone (13) sous ladite au moins une ouverture (3) est protégée par des tôles (12) du reste de la cage (1), et
dans lequel l'extrémité supérieure (11) d'un tuyau d'air froid (5) dépasse à l'intérieur de ladite zone,
dans lequel la chambre d'air froid (10) a dans la zone de fond une ouverture (7), dans laquelle le tuyau d'air froid (5) débouche,
dans lequel la chambre d'air froid (10) est en communication fluidique avec l'au moins une autre chambre (17a) séparée,
dans lequel les dispositifs électriques et/ou électroniques sont disposés dans l'au moins une chambre séparée,
dans lequel l'au moins une autre chambre (17a) est configurée pour que l'air froid sous pression qui refroidit ce faisant les dispositifs (16) électriques et/ou électroniques passe, et
dans lequel l'ensemble composé du capot (15) et de la chambre (17a) est configuré de telle sorte que l'air ainsi réchauffé sort de l'au moins une autre chambre (17a) séparée puis en bas du capot (15) et quitte la cage (1) par des ouvertures (4) dans l'au moins un couvercle (2).

2. Répartiteur encastré selon la revendication 1, **caractérisé en ce**
**que** l'au moins une autre chambre (17a) séparée est fixée latéralement au niveau de la chambre d'air froid (10) .

3. Répartiteur encastré selon la revendication 1, **caractérisé en ce**
**que** respectivement une autre chambre (17a) séparée est fixée au niveau des deux côtés se faisant face de la chambre d'air froid (10).

4. Répartiteur encastré selon l'une quelconque des revendications 1 à 3,
**caractérisé en ce**
**qu'**est disposé dans la chambre d'air froid (10) au moins un ventilateur (9), qui est configuré pour aspirer de l'air froid.

5. Répartiteur encastré selon l'une quelconque des revendications 1 à 4,
**caractérisé en ce**
**que** la chambre d'air froid (10) est en communication fluidique avec la/les autre(s) chambre(s) (17a) par des ouvertures (19) dans une paroi latérale/des parois latérales de sorte que l'air froid est poussé dans l'autre/les autres chambre(s) (17a).

6. Répartiteur encastré selon l'une quelconque des revendications 1 à 5,
**caractérisé en ce**
**que** celui-ci est configuré pour
**que** l'air froid entre dans la zone supérieure de l'autre/des autres chambre(s) (17a) et sorte par son/leur fond ouvert.

7. Répartiteur encastré selon l'une quelconque des revendications 1 à 6,
**caractérisé en ce**
**que** l'extrémité du tuyau d'air froid (5) est bloquée par une fixation (14) dans la cage (1) dans la position, dans laquelle elle vient en prise avec l'ouverture (7) de la zone de fond de la chambre d'air froid (10).

8. Répartiteur encastré selon l'une quelconque des revendications 1 à 7,
**caractérisé en ce**
**que** l'ouverture (7) de la zone de fond de la chambre d'air froid (10) est réalisée dans une paroi de fond (21) s'étendant de manière inclinée, et que la fixation (14) bloque de manière correspondante de manière inclinée l'extrémité du tuyau d'air froid (5) de telle manière que lors du pivotement du capot (15), l'extrémité du tuyau d'air froid (5) peut sortir lisse de l'ouverture (7) et peut entrer à nouveau dans l'ouverture (7) .

9. Répartiteur encastré selon l'une quelconque des revendications 1 à 8,
**caractérisé en ce**
**que** trois zones, par exemple avec au total neuf ouvertures (4) servant à la sortie de l'air réchauffé sont réalisées dans l'au moins un couvercle (2).
